(19) Europäisches Patentamt
European Patent Office
Office européen des brevets

(11) **EP 2 698 830 A1**

(12) **EUROPEAN PATENT APPLICATION**
published in accordance with Art. 153(4) EPC

(43) Date of publication:
**19.02.2014 Bulletin 2014/08**

(51) Int Cl.:
***H01L 31/048*** (2006.01)   ***C08J 5/18*** (2006.01)
***C08L 23/08*** (2006.01)

(21) Application number: **12771385.7**

(22) Date of filing: **12.04.2012**

(86) International application number:
**PCT/JP2012/002551**

(87) International publication number:
**WO 2012/140897 (18.10.2012 Gazette 2012/42)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.04.2011 JP 2011089968**

(71) Applicant: **Mitsui Chemicals Tohcello, Inc.
Tokyo 101-8485 (JP)**

(72) Inventors:
• **SATO, Rie
Ibaraki 312-0002 (JP)**

• **KUBO, Shinichiro
Ibaraki 312-0002 (JP)**
• **KIDO, Hiroyasu
Ibaraki 312-0002 (JP)**

(74) Representative: **Raynor, Stuart Andrew
J A Kemp
14 South Square
Gray's Inn
London WC1R 5JJ (GB)**

(54) **RESIN SHEET FOR SEALING SOLAR CELL, SOLAR CELL MODULE USING SAME, AND METHOD FOR MANUFACTURING SOLAR CELL MODULE**

(57) The present invention provides a resin sheet for solar cell encapsulation, which has excellent transparency and bonding strength for a long period of time, while being reduced in shrinkage when heated. A resin sheet for solar cell encapsulation of the present invention comprises an ethylene-vinyl acetate copolymer having a vinyl acetate content of 10-47% by mass and an organic per-oxide. The ethylene-vinyl acetate copolymer contains an ethylene-vinyl acetate copolymer (EV1) which has a molecular weight distribution (Mw/Mn) of 3.0 or less. The resin sheet for solar cell encapsulation contains the organic peroxide in an amount of 0.1-5% by mass.

**Description**

**Technical Field**

The present invention relates to a resin sheet for solar cell encapsulation for encapsulating solar cells in a solar cell module, to a solar cell module having the resin sheet, and to a method for manufacturing a solar cell module.

**Background Art**

In recent years, solar photovoltaic generation has been highlighted as a clean energy, and development of a solar cell module for a solar photovoltaic generation has been in progress. A solar cell module is, in general, constituted of a protective glass, a resin sheet for solar cell encapsulation, solar cells, a resin sheet for solar cell encapsulation, and a back film. In producing a solar cell module, a resin sheet for solar cell encapsulation is heated in a state where the respective layers are laminated, so that a resin constituting the resin sheet for solar cell encapsulation melts to encapsulate solar cells and further adhere to a protective glass and a back film.

For a general resin sheet for solar cell encapsulation, an ethylene-vinyl acetate copolymer (hereinafter, also referred to as "EVA") excellent in transparency, flexibility, processability, durability is used as a main component (see, for example, PTL 1).

**Citation List**

**Patent Literature**

PTL 1: Japanese Patent Application Laid-Open No. 6-177412

**Summary of Invention**

**Technical Problem**

However, a resin sheet for solar cell encapsulation using a conventional ethylene-vinyl acetate copolymer as a main component exhibits large shrinkage upon heating. In the case where shrinkage of a resin sheet for solar cell encapsulation is large when the sheet is heat-laminated upon encapsulation of solar cells, it results in displacement and/or damage of the solar cells to be encapsulated.

Accordingly, the present invention provides a resin sheet for solar cell encapsulation with little shrinkage at the time of heating that is excellent in a long term reliability such as transparency and adhesive strength.

**Solution to Problem**

The present inventors have focused attention on a molecular weight distribution of an ethylene-vinyl acetate copolymer contained in a resin sheet for solar cell encapsulation and found that a shrinkage of the resin sheet for solar cell encapsulation at the time of heating is reduced by narrowing the molecular weight distribution of an ethylene-vinyl acetate copolymer to be used for the resin sheet for solar cell encapsulation.

The present invention relates to a resin sheet for solar cell encapsulation described below.

[1] A resin sheet for solar cell encapsulation, comprising: an ethylene-vinyl acetate copolymer having a vinyl acetate content of 10 to 47% by mass; and an organic peroxide, in which
the ethylene-vinyl acetate copolymer contains an ethylene-vinyl acetate copolymer EV1 having a molecular weight distribution (Mw/Mn) of 3.0 or less, and
a content of the organic peroxide is 0.1 to 5% by mass.

[2] The resin sheet according to [1], in which the ethylene-vinyl acetate copolymer has a melt flow rate (MFR) of 5 to 45 g/10 minutes at 190°C under a load of 2160 g according to ASTM D 1238.

[3] The resin sheet according to [1] or [2], in which a relation of the vinyl acetate content $C_{VA}$ (% by mass) in the ethylene-vinyl acetate copolymer and a melt flow rate (MFR) of the ethylene-vinyl acetate copolymer at 190°C under a load of 2160 g according to ASTM D 1238 satisfies the following Expression (1):

$$MFR > 0.748 \times C_{VA}^2 - 35.4 \times C_{VA} + 423 \qquad \text{Expression (1)}.$$

[4] The resin sheet according to any one of [1] to [3], in which the ethylene-vinyl acetate copolymer EV1 is produced by a tubular method.

The second aspect of the present invention relates to a resin sheet for solar cell encapsulation described below.

[5] The resin sheet according to any one of [1] to [4], in which the ethylene-vinyl acetate copolymer further contains an ethylene-vinyl acetate copolymer EV2 having a molecular weight distribution (Mw/Mn) of more than 3.0.

[6] The resin sheet according to [5], in which a mass ratio of the ethylene-vinyl acetate copolymer EV1 to the ethylene-vinyl acetate copolymer EV2, EV1/EV2, is 99/1 to 60/40.

[7] Use of a resin sheet according to any one of [1] to [6] for encapsulating a solar cell.

[8] A solar cell module including the resin sheet according to any one of [1] to [6].

[9] A method for producing a solar cell module including the resin sheet according to any one of [1] to [6], including:

laminating a solar cell, the resin sheet for solar cell encapsulation, and a protective material in the order named and heating the resin sheet for solar cell encapsulation to a temperature at which temperature the organic peroxide does not substantially decompose and the ethylene-vinyl acetate copolymer melts; and

increasing the temperature of the resin sheet for solar cell encapsulation to a temperature equal to or higher than a temperature at which the ethylene-vinyl acetate copolymer crosslink by the organic peroxide in the resin sheet for solar cell encapsulation.

**Advantageous Effects of Invention**

According to the present invention, a resin sheet for solar cell encapsulation with little shrinkage at the time of heating that is excellent in transparency and adhesive strength over a long period of time can be provided.

**Description of Embodiments**

1. Resin sheet for solar cell encapsulation

A resin sheet for solar cell encapsulation of the present invention contains an ethylene-vinyl acetate copolymer having a vinyl acetate content of 10 to 47% by mass and an organic peroxide. The resin sheet for solar cell encapsulation may contain additives such as a crosslinking aid and an ultraviolet absorber as necessary.

In the resin sheet for solar cell encapsulation of the present invention, it is preferable that the ethylene-vinyl acetate copolymer and the organic peroxide are contained in a same layer. Moreover, the resin sheet for solar cell encapsulation may have a constitution in which a layer containing the ethylene-vinyl acetate copolymer and the organic peroxide and other layers are laminated.

(Ethylene-vinyl acetate copolymer)

An ethylene-vinyl acetate copolymer is a copolymer of ethylene and vinyl acetate and is often a random copolymer. The ethylene-vinyl acetate copolymer in the present invention has a vinyl acetate content of 10 to 47% by mass, preferably 13 to 35% by mass. When the vinyl acetate content is in this range, a resin sheet for solar cell encapsulation made therefrom is excellent in adhesive properties, weatherability, transparency, and mechanical properties. Moreover, sheet forming properties become good for forming the resin sheet for solar cell encapsulation. The vinyl acetate content can be measured according to JIS K6924-2. Specifically, the vinyl acetate content can be measured by completely saponifying the ethylene-vinyl acetate copolymer with a potassium hydroxide solution followed by adding a known amount of sulfuric acid equal to or more than the equivalent amount, and then titrating the excess amount of sulfuric acid with a sodium hydroxide solution

In addition, the ethylene-vinyl acetate copolymer is preferably a binary copolymer consisting of only ethylene and vinyl acetate; however, in addition to the monomer, may contain, for example, a vinyl ester monomer such as vinyl formate, vinyl glycolate, vinyl propionate, and vinyl benzoate; and an acrylic monomer such as acrylic acid, methacrylic acid, or a salt thereof or an alkyl ester thereof as a copolymer component. In the case where a copolymer component in addition to ethylene and vinyl acetate is contained, the amount of the copolymer component in the ethylene-vinyl acetate copolymer is preferably 0.5 to 5% by mass.

A melt flow rate of the ethylene-vinyl acetate copolymer at 190°C under a load of 2160 g according to ASTM D 1238 (hereinafter, also referred to as "MFR: ASTM D 1238") is preferably 5 to 45 g/10 minutes, more preferably 5 to 40 g/10 minutes, even more preferably 10 to 30 g/10 minutes because the viscosity is suitable for melt kneading.

As for the ethylene-vinyl acetate copolymer, it is preferable that a relation of the vinyl acetate content ($C_{VA}$: % by mass) in the ethylene-vinyl acetate copolymer and the above melt flow rate (MFR) of the ethylene-vinyl acetate copolymer satisfies the following Expression (1):

$$MFR > 0.748 \times C_{VA}^{2} - 35.4 \times C_{VA} + 423 \qquad \text{Expression (1)}.$$

The ethylene-vinyl acetate copolymer that satisfies the Expression (1) has a higher MFR, a higher transparency, and a lower heat shrinkage rate compared with conventional ethylene-vinyl acetate copolymers having an equivalent vinyl acetate content.

The ethylene-vinyl acetate copolymer contains an ethylene-vinyl acetate copolymer EV1. A molecular weight distribution (Mw/Mn) of the ethylene-vinyl acetate copolymer EV1 is 3.0 or less, preferably 2.5 or less. By setting the molecular weight distribution (Mw/Mn) of the ethylene-vinyl acetate copolymer EV1 to 3.0 or less, shrinkage of the resin sheet for solar cell encapsulation by heating can be reduced. The reason is because crosslink properties are improved (crosslink density increases through a crosslinking reaction) when the molecular weight distribution (Mw/Mn) of the ethylene-vinyl acetate copolymer EV1 is 3.0 or less, but not necessarily limited to this. The possible mechanism by which the crosslinking properties are improved is that curing of the resin occurs homogeneously due to reduced amounts of components having extremely small molecular weights and extremely large molecular weights.

The above molecular weight distribution (Mw/Mn) of the ethylene-vinyl acetate copolymer is a ratio of weight average molecular weight (Mw) to number average molecular weight (Mn) measured by gel permeation chromatography (GPC).

The ethylene-vinyl acetate copolymer may further contain an ethylene-vinyl acetate copolymer EV2. The ethylene-vinyl acetate copolymer EV2 has a feature of having a molecular weight distribution (Mw/Mn) of more than 3.0.

In addition, a vinyl acetate content of the ethylene-vinyl acetate copolymer EV2 is 10 to 47% by mass, preferably 13 to 35% by mass. The vinyl acetate content may be the same as or different from the vinyl acetate content of the ethylene-vinyl acetate copolymer EV 1.

Moreover, an MFR of the ethylene-vinyl acetate copolymer EV2 is preferably 5 to 45 g/10 minutes, more preferably 5 to 40 g/10 minutes, even more preferably 10 to 30 g/10 minutes. The value of the MFR may be the same as or different from that value of the MFR of the ethylene-vinyl acetate copolymer EV1.

A composition ratio of the ethylene-vinyl acetate copolymer EV1 to the ethylene-vinyl acetate copolymer EV2, EV1/EV2, in a ratio by mass, is preferably 99/1 to 60/40, more preferably 99/1 to 70/30.

The ethylene-vinyl acetate copolymer EV2 tends to have a large heat shrinkage as a molded sheet compared with the ethylene-vinyl acetate copolymer EV1. A heat shrinkage rate of a molded sheet obtained from a composition can be adjusted by changing a blending ratio of these copolymers.

By using a combination of the ethylene-vinyl acetate copolymer EV1 and the ethylene-vinyl acetate copolymer EV2 at the above composition ratio, the resin sheet for solar cell encapsulation of the present invention can be produced, suppressing a neck-in at the time of production. Moreover, the resin sheet for solar cell encapsulation that enables to adjust a shrinkage rate arbitrarily depending on a process or a product specification can be obtained. Here, "neck-in" is a phenomenon that the width of a film of the resin composition extruded from a T die becomes narrower than the width of the outlet of the T die.

The ethylene-vinyl acetate copolymer EV1 and the ethylene-vinyl acetate copolymer EV2 can be dry-blended, melt-kneaded and molded by extrusion molding with an extruder. In addition, a composition that has been melt-kneaded and pelletized in advance may be molded by melt molding.

The resin sheet for solar cell encapsulation may further contain two or more ethylene-vinyl acetate copolymers each having, for example, a different vinyl acetate content and melt flow rate. When two or more ethylene-vinyl acetate copolymers are used, it is preferable that the above numerical range and expression are satisfied by the total ethylene-vinyl acetate copolymers.

Moreover, the resin sheet for solar cell encapsulation may contain a resin other than the ethylene-vinyl acetate copolymer. In this case, the content of the resin other than the ethylene-vinyl acetate copolymer is preferably 0 to 10% by mass, more preferably 0 to 5% by mass.

(Method for producing ethylene-vinyl acetate copolymer)

A method for producing an ethylene-vinyl acetate copolymer in the present invention is not particularly limited. However, it is preferable to produce the ethylene-vinyl acetate copolymer by a tubular method in order to make the molecular weight distribution (Mw/Mn) of the ethylene-vinyl acetate copolymer 3.0 or less. The ethylene-vinyl acetate copolymer produced by other methods including an autoclave method usually has a molecular weight distribution (Mw/Mn) of more than 3.0.

It is thus preferable to produce the ethylene-vinyl acetate copolymer EV1 in the present invention by a tubular method, and, thereby, to realize the above molecular weight distribution. The tubular method is a method in which a radical polymerization of ethylene and vinyl acetate is carried out using a free radical catalyst under a high pressure condition in a tubular reactor, and examples thereof include a method described in Japanese Patent Application Laid-Open No. 62-273214.

The ethylene-vinyl acetate copolymer obtained by a tubular method has less random sequences of an ethylene unit and a vinyl acetate unit compared with highly random copolymers obtained by usual radical polymerization methods (for example, an autoclave method). Namely, the ethylene-vinyl acetate copolymer obtained by a tubular method has a polymer structure and physical properties somewhat similar to block copolymers.

Hereinafter, the method for producing the ethylene-vinyl acetate copolymer by a tubular method is specifically explained. Vinyl acetate, a free radical catalyst, and a radical chain transfer agent or auxiliaries, and so on as necessary are supplied from an inlet of a reactor installed at one end of a tubular reactor. A method for supplying is not particularly limited, and these materials can be supplied by using, for example, a high pressure pump. In addition, ethylene may be supplied from an inlet of a reactor or from a side portion of a tubular reactor.

On this occasion, a pressure of the inlet of a reactor is preferably set to 2300 to 3000 kg/cm$^2$ (225.6 to 294.2 MPa), preferably 2400 to 2800 kg/cm$^2$ (235.4 to 274.6 MPa). At a pressure equal to or lower than the lower limit value, efficiency of the polymerization reaction of ethylene and vinyl acetate may decrease. Moreover, it is preferable to set a pressure equal to or lower than the upper limit value from a view point of production efficiency.

Moreover, it is preferable to set a temperature of a tubular reactor (polymerization temperature) in such a way that an average reaction temperature becomes 190 to 230°C. When the polymerization temperature is lower than the lower limit value, the polymerization may take a long period of time, and a large amount of a catalyst may be required, when the polymerization time is attempted to be shortened. On the other hand, when the polymerization temperature exceeds the upper limit value, control of the polymerization may become difficult.

A free radical catalyst to be used for the polymerization may be those generally used as a radical initiator and is preferably an azo compound such as 2,2'-azobis-(2,4-dimethyl-valeronitrile), 2,2'-azobis-(2,4,4-trimethyl-valeronitrile), 2,2'-azobisisobutyronitrile, or 2,2'-azobis-(4-methoxy-2,4-dimethyl-valeronitrile); an alkyl perester such as t-butyl peroxyneodecanoate or t-butyl perpivalate; a peroxydicarbonate such as bis-(4-t-butylcyclohexyl) peroxydicarbonate, dicyclohexyl peroxydicarbonate, bis(2-ethylhexyl)di-sec-butyl peroxydicarbonate, or diisopropyl peroxydicarbonate; a peroxide such as acetyl peroxide, dilauroyl peroxide, didecanoyl peroxide, dioctanoyl peroxide, or dipropyl peroxide; or the like.

A content of the above free radical catalyst is preferably 1 to 55 ppm by mass, more preferably 5 to 30 ppm by mass based on the total amount of raw materials to be supplied to a tubular reactor. In the case where the content of the above free radical catalyst is lower than the lower limit value, a catalyst efficiency may be poor and the polymerization may not progress. On the other hand, a content of the above free radical catalyst exceeds the upper limit, the control of polymerization may become difficult, and also the catalyst may remain in the resin after the polymerization to cause postpolymerization.

At the time of polymerization by tubular method, a radical chain transfer agent is used as necessary. Examples of the radical chain transfer agent include, for example, saturated aliphatic hydrocarbons; halogen-substituted hydrocarbons; saturated aliphatic alcohols; saturated aliphatic carbonyl compounds; and aromatic compounds such as toluene, ethylbenzene, and xylene. A content amount of the radical chain transfer agent is preferably 0.2 to 10 mol%, more preferably 0.5 to 5 mol% based on the total amount of raw materials. By using the radical chain transfer agent in such a range, a radical chain reaction of ethylene and vinyl acetate can be facilitated.

The ethylene-vinyl acetate copolymer EV2 can be produced by an autoclave method.

The autoclave method is generally a method for producing an ethylene-vinyl acetate copolymer, and is described in, for example, Japanese Patent Application Laid-Open Nos. 11-116637 and 60-053513, and so on. The autoclave method is usually a method for producing an ethylene-vinyl acetate copolymer by using a high pressure radical polymerization method in the presence of an appropriate amount of a catalyst at a high pressure and a high temperature in a pressure resistant reaction vessel or reaction chamber. Moreover, the autoclave method is a method for producing an ethylene-vinyl acetate copolymer having a certain level of a molecular weight distribution as described in Comparative Example of Japanese Patent Application Laid-Open No. 10-130307. Examples of an ethylene-vinyl acetate copolymer EV2 available in the market produced by this method include, for example, "Sumitate" manufactured by Sumitomo Chemical Co., Ltd., "Taisox EVA" manufactured by Formosa Plastics Corporation, "Seetec EVA" manufactured by Honam Petrochemical Corporation, "Ateva" manufactured by Celanese Corporation, and "Evaflex" manufactured by DuPont-Mitsui Polychemicals Co., Ltd., and like.

(Organic peroxide)

The resin sheet for solar cell encapsulation of the present invention contains 0.1 to 5% by mass, preferably 0.2 to 2% by mass of an organic peroxide. Containing the organic peroxide in the resin sheet for solar cell encapsulation allows crosslinking of the above ethylene-vinyl acetate copolymer. By crosslinking the above ethylene-vinyl acetate copolymer, the heat resistance and weatherability of the resin sheet for solar cell encapsulation become good.

In light of a productivity of a solar cell module, an organic peroxide may preferably have a half-life of 10 hours or less and a decomposition temperature of 105°C or less. Moreover, an organic peroxide may preferably have a maximum storage temperature of 10°C or more from the stand point of safety. Examples of such an organic peroxide include dilauroylperoxide, 1,1,3,3-tetramethylbutylperoxy-2-ethylhexanoate, dibenzoylperoxide, cyclohexanoneperoxide, di-t-butyl perphthalate, cumenhydroperoxide, t-butyl hydroperoxide, 2,5-dimethyl-2,5-di(t-butylperoxy)hexene, 2,5-dimethyl-2,5-di(t-butylperoxy)hexane, t-amylperoxy-2-ethylhexanoate, t-butylperoxy-2-ethylhexanoate, t-butylperoxyisobutyrate, t-butylperoxy maleic acid, 1,1 1-di(t-amylperoxy)-3,3,5-trimethylcyclohexane, 1,1-di(t-amylperoxy)cyclohexane, t-amylperoxyisononanoate, t-amylperoxy normal-octoate, 1,1-di(t-butylperoxy)-3,3,5-trimethylcyclohexane, 1,1-di(t-butylperoxy)cyclohexane, t-butylperoxyisopropylcarbonate, t-butylperoxy-2-ethylhexylcarbonate, 2,5-dimethyl-2,5-di(benzoylperoxy)hexane, t-amyl-peroxybenzoate, t-butylperoxyacetate, t-butylperoxyisononanoate, t-butylperoxybenzoate, 2,2-di(butylperoxy)butane, n-butyl-4,4-di(t-butylperoxy)butyrate, methylethylketoneperoxide, ethyl 3,3-di(t-butylperoxy)butyrate, dicumylperoxide, t-butylcumylperoxide, t-butylperoxybenzoate, di-t-butylperoxide, and 1,1,3,3-tetramethylbutylhydroperoxide, acetylacetoneperoxide.

Among these, 2,5-dimethyl-2,5-di(t-butylperoxy)hexene, 2,5-dimethyl-2,5-di(t-butylperoxy)hexane, t-butylperoxy-2-ethylhexylcarbonate, and t-butylperoxybenzoate are preferable.

(Additives)

The resin sheet for solar cell encapsulation of the present invention may possibly contain, in addition to the above ethylene-vinyl acetate copolymer and organic peroxide, additives such as a crosslinking aid, an adhesion promoter, an ultraviolet absorber, a light stabilizer, and an antioxidizing agent, as necessary.

Examples of the crosslinking aid include an allyl group-containing compound such as triallyl isocyanurate and trimethallyl isocyanurate. The crosslinking aid is preferably 10 parts by mass or less based on 100 parts by mass of the ethylene-vinyl acetate copolymer.

Moreover, examples of the adhesion promoter include vinyltriethoxysilane, vinyltrichlorosilane, vinyltris(β-methoxy-ethoxy)silane, β-(3,4-epoxycyclohexyl)-ethyltrimethoxysilane, γ-glycidoxypropyl-trimethoxysilane, and γ-aminopropyltriethoxysilane. The adhesive promoter is preferably 5 parts by mass or less based on 100 parts by mass of an ethylene-vinyl acetate copolymer.

Examples of the ultraviolet absorber include benzophenone-based compounds such as 2-hydroxy-4-methoxybenzophenone, 2,2-dihydroxy-4-methoxybenzophenone, 2-hydroxy-4-methoxy-2-carboxybenzophenone, and 2-hydroxy-4-n-octoxybenzophenone; benzotriazole-based compounds such as 2-(2-hydroxy-3,5-di-t-butylphenyl)benzotriazole, 2-(2-hydroxy-5-methylphenyl)benzotriazole, and 2-(2-hydroxy-5-t-octylphenyl)benzotriazole; and salicylic acid ester-based compounds such as phenyl salicylate and p-octylphenylsalicylate.

As a light stabilizer, a hindered amine based light stabilizer can be used. As an antioxidizing agent, a hindered phenol-based or a phosphite-based antioxidant can be used. The ultraviolet absorber, the light stabilizer and the antioxidant can be used in amounts so long as the object and effect of the present invention are obtained.

(Resin sheet for solar cell encapsulation)

The resin sheet for solar cell encapsulation of the present invention comprises an ethylene-vinyl acetate copolymer and an organic peroxide. A layer constitution of the resin sheet for solar cell encapsulation of the present invention is not particularly limited. For example, the resin sheet for solar cell encapsulation may be constituted of only one layer comprising the vinyl acetate copolymer and the organic peroxide, or may be a laminated constituted of two or more layers having a layer comprising the ethylene-vinyl acetate copolymer and the organic peroxide and one or more other layers laminated in the range where the object of the present invention is not impaired.

The thickness of the resin sheet for solar cell encapsulation is not particularly limited; however, it is usually from about 0.2 to about 1.2 mm.

The shrinkage property of the resin sheet for solar cell encapsulation of the present invention at the time of heating expressed as a heat shrinkage rate measured according to JIS C2318-1997 is preferably 25% or less, more preferably 15% or less. By setting the shrinkage rate to the above shrinkage rate, possible displacement of solar cells and/or damage to the solar cells in a solar cell module during manufacture of solar cell module can be eliminated.

A specific method for measuring a heat shrinkage rate is as follows. Five test pieces of 20 mm in width and 150 mm in length are taken from the resin sheet for solar cell encapsulation, and gauge marks are put 100 mm apart on the central part of each test piece. These samples are hung vertically in a hot-air circulating thermostatic chamber maintained at a temperature of 75°C, taken out after heating for 15 minutes, and left at room temperature for 30 minutes, and then a gauge length is measured. After that, a shrinkage rate is calculated in accordance with the following expression. The average value is determined, and the average value is set as the heat shrinkage rate.

$$\Delta L\ (\%) = [(L_0 - L)/L_0] \times 100$$

$\Delta L$: shrinkage rate (%)
$L_0$: gauge length before heating (mm)
$L$: gauge length after heating (mm)

Moreover, a gel content of the resin sheet for solar cell encapsulation after heating at 150°C for 7 minutes is preferably 75% or more, more preferably 70 to 98%, even more preferably 80 to 95%. The gel content is a fraction by mass of an undissolved component obtained by immersing 1 g of the resin sheet for solar cell encapsulation after heating in 100 mL of xylene, heating at 110°C for 24 hours followed by filtration through a wire mesh filter of 20 meshes. The resin sheet for solar cell encapsulation having the above gel content is good in crosslinking properties and good in heat resistance and weatherability.

In order to set the gel content of the resin sheet for solar cell encapsulation in the above range, the content, for example, of the organic peroxide or other additives may appropriately be selected.

(Method for producing resin sheet for encapsulating solar cell)

A method for producing a resin sheet for solar cell encapsulation of the present invention is not particularly limited. For example, the ethylene-vinyl acetate copolymer and the organic peroxide, and further other additives as necessary are dry-blended in advance and supplied into an extruding machine through a hopper thereof. Next, the ethylene-vinyl acetate copolymer and the organic peroxide, and further other additives as necessary are extruded in a sheet form at a temperature that does not decompose the organic peroxide. In this way, the resin sheet for solar cell encapsulation of the present invention can be obtained. A molding can be carried out by a publicly known method using a T-die extrusion machine, a calendar molding machine, an inflation molding machine, or the like.

Alternatively, a sheet of an ethylene-vinyl acetate copolymer composition containing no organic peroxide may be produced by the above method in advance, and the organic peroxide may be added to the produced sheet by an immersion method.

2. Solar cell module

The resin sheet for solar cell encapsulation of the present invention is used to encapsulate solar cells in a solar cell module. Examples of a constitution of a solar cell module for which the resin sheet for solar cell encapsulation of the present invention is used include, for instance, a constitution in which an upper transparent protective material/the resin sheet for solar cell encapsulation (namely, a light receiving side sheet)/solar cells/the resin sheet for solar cell encapsulation (namely, a back side sheet)/a lower protective material are laminated in this order. However, a constitution of the solar cell module is not limited to this, the solar cell module may have a constitution having no back side sheet or lower protective material, namely a constitution in which an upper transparent protective material/the resin sheet for solar cell encapsulation/solar cells are laminated in this order, or the like.

As the solar cells, various types of solar cells can be used, including silicon as single crystal silicon, polycrystal silicon, and amorphous silicon; and group III-V and group II-VI compound semiconductors such as gallium-arsenic, copper-indium-selenium, and cadmium-tellurium.

Examples of an upper transparent protective material that constitutes a solar cell module include glass, an acrylic resin, a polycarbonate, a polyester, and a fluorine-containing resin.

Examples of a lower protective material include a single or multi-layered sheet of a metal, various thermoplastic resins, or the like. For example, a single or multi-layered protective material of an inorganic material such as a metal such as tin, aluminum, stainless steel, or glass; and of a polyester, an inorganic material deposited polyester, a fluorine-containing resin, a polyolefin, and the like can be exemplified.

The resin sheet for solar cell encapsulation obtained in the present invention shows good adhesive properties to these upper transparent protective materials and lower protective materials.

The production of the solar cell module of the above constitution is usually carried out by preparing a laminated product of the upper transparent protective material/the resin sheet for solar cell encapsulation (namely, a light receiving side sheet)/solar cells/the resin sheet for solar cell encapsulation (namely, a back side sheet)/the lower protective material in this order and heating the laminated product.

More specifically, solar cells, an upper transparent protective material and a lower protective material, and the resin sheet for solar cell encapsulation are temporarily adhered by heating the resin sheet for solar cell encapsulation to a temperature at which temperature the organic peroxide contained in the resin sheet for solar cell encapsulation does not substantially decompose and the ethylene-vinyl acetate copolymer melts. Next, a sufficient adhesion between the above respective members and the resin sheet for solar cell encapsulation and, further, crosslinking of the ethylene-vinyl acetate copolymer in the resin sheet for solar cell encapsulation are carried out by raising the temperature. The temperature for adhesion and crosslinking may be a temperature at which a sufficient crosslinking rate is obtained and a blister does not occur, and can be set to a temperature range of, for example, about 100 to about 180°C.

**Examples**

Example 1

0.1 parts by mass of 2,5-dimethyl-2,5-bis(t-butylperoxy)hexane, 0.5 parts by mass of t-butylperoxy-2-ethylhexylcarbonate, 0.8 parts by mass of triallylisocyanurate, and 0.5 parts by mass of γ-methacryloxypropyltrimethoxysillane were blended to 100 parts by mass of an ethylene-vinyl acetate copolymer EVA-1 (vinyl acetate content: 28% by mass, MFR at 190°C under a load of 2160 g: 20 g/10 minutes, Mw/Mn: 2.19) synthesized by a tubular method to obtain a resin composition. The obtained resin composition was extruded into a resin sheet for solar cell encapsulation having a thickness of about 600 μm with a T-die extrusion machine.
Measurement of a crosslinking property (gel content), measurement of heat shrinkage rate, a high temperature and high humidity durability test, a high temperature durability test, and a weatherability test were carried out for the obtained resin sheet for solar cell encapsulation by the methods (1) to (5) described below. The results are shown in Table 1.

(1) Measurement of crosslinking property (gel content)

A crosslinked resin sheet for solar cell encapsulation sheet in which the ethylene-vinyl acetate copolymer was crosslinked was obtained by heating the resin sheet for solar cell encapsulation for 7 minutes under pressure with a compression molding machine of 150°C. 1 g of the crosslinked sheet was immersed in 100 mL of xylene, and, after heating at 110°C for 24 hours, the crosslinking property was evaluated by determining a fraction by mass of an undissolved component when filtered through a wire mesh filter of 20 meshes.

(2) Measurement of heat shrinkage rate

A heat shrinkage rate was calculated according to JIS C2318-1997. Specifically, five test pieces of 20 mm in width and 150 mm in length were taken from the machine direction of the produced resin sheet for solar cell encapsulation, and gauge marks were put 100 mm apart on the central part of each test piece. These samples were hung vertically in a hot-air circulating thermostatic chamber maintained at a temperature of 75°C, taken out after heating for 15 minutes, and left at room temperature for 30 minutes, and then a gauge length was measured. After that, a shrinkage rate was calculated by the following expression. The average value was determined, and the average value was set as the heat shrinkage rate.

$$\Delta L(\%) = [(L_0 - L)/L_0] \times 100$$

In the above expression, $\Delta L$ represents a shrinkage rate (%), $L_0$ represents a gauge length before heating (mm), and $L$ represents gauge length after heating (mm).

(3) High temperature and high humidity durability test

The obtained resin sheet for solar cell encapsulation was laminated between 2 glass sheets, and a vacuum lamination was carried out at 125°C. Next, heating was carried out at 150°C for 30 minutes, and the obtained test piece was exposed to 85°C, 85%RH for 2000 hours. After that, a total light transmittance was measured according to JIS K7361.
As for an adhesion strength test, the obtained resin sheet for solar cell encapsulation was laminated on a glass sheet, and vacuum lamination was carried out at 125°C. Next, heating was carried out at 150°C for 30 minutes, and the obtained test piece was exposed to 85°C, 85%RH for 2000 hours. After that, the adhesion strength was evaluated according to JIS K6854 with an Autograph (manufactured by Shimadzu Corporation) by a measurement result of a test piece of 10 mm in width peeled at 300 mm/min by 180° peel method.

(4) High temperature durability test

The obtained resin sheet for solar cell encapsulation was laminated on a glass sheet, and a vacuum lamination was carried out at 125°C. Next, heating was carried out at 150°C for 30 minutes, and the obtained test piece was exposed to an oven of 120°C for 1000 hours. Thereafter, the high temperature durability was evaluated according to JIS K6854 with an Autograph (manufactured by Shimadzu Corporation) by a measurement result of a test piece of 10 mm in width peeled at 300 mm/min by a 180° peel method.

(5) Weatherability test

The obtained resin sheet for solar cell encapsulation was laminated on a glass sheet, and vacuum lamination was carried out at 125°C and then heated at 150°C for 30 minutes. The obtained test piece was processed with Xenon Weather Meter manufactured by Suga Test Instruments Co., Ltd. under the condition as described in IEC 61215. A wavelength of irradiation light at the time of processing was 280 nm to 385 nm, the irradiation dose was set to 180 kWh/m$^2$. Thereafter, the weatherability was evaluated according to JIS K6854 with Autograph (manufactured by Shimadzu Corporation) by a measurement result of a test piece of 10 mm in width peeled at 300 mm/min by 180° peel method.

Example 2

A resin sheet for solar cell encapsulation was produced in exactly the same way as in Example 1 except that the ethylene-vinyl acetate copolymer EVA-2 (vinyl acetate content: 28% by mass, MFR at 190°C under a load of 2160 g: 40 g/10 minutes, Mw/Mn: 2.43) synthesized by a tubular method was used in place of EVA-1. Measurement of a crosslinking property (gel content), measurement of heat shrinkage rate, a high temperature and high humidity durability test, a high temperature durability test, and a weatherability test were carried out for the resin sheet for solar cell encapsulation. The results are shown in Table 1.

Example 3

A resin sheet for solar cell encapsulation was produced in exactly the same way as in Example 1 except that 70 parts by mass of EVA-1 and 30 parts by mass of EVA-3 (vinyl acetate content: 28% by mass, MFR at 190°C under a load of 2160 g: 15 g/10 minutes, Mw/Mn: 3.39) synthesized by an autoclave method were used in place of the 100 parts by mass of EVA-1. A measurement of a crosslinking property (gel content), measurement of heat shrinkage rate, a high temperature and high humidity durability test, a high temperature durability test, and a weatherability test were carried out for the resin sheet for solar cell encapsulation. The results are shown in Table 1.

Example 4

A resin sheet for solar cell encapsulation was produced in exactly the same way as in Example 1 except that 50 parts by mass of EVA-1 and 50 parts by mass of EVA-3 were used in place of the 100 parts by mass of EVA-1. Measurement of a crosslinking property (gel content), measurement of heat shrinkage rate, a high temperature and high humidity durability test, a high temperature durability test, and a weatherability test were carried out for the resin sheet for solar cell encapsulation. The results are shown in Table 1.

Example 5

A resin sheet for solar cell encapsulation was produced in exactly the same way as in Example 1 except that 30 parts by mass of EVA-1 and 70 parts by mass of EVA-3 were used in place of the 100 parts by mass of EVA-1. Measurement of a crosslinking property (gel content), measurement of heat shrinkage rate, a high temperature and high humidity durability test, a high temperature durability test, and a weatherability test were carried out for the resin sheet for solar cell encapsulation. The results are shown in Table 1.

Comparative Example 1

A resin sheet for solar cell encapsulation was produced in exactly the same way as in Example 1 except that EVA-3 was used in place of EVA-1. Measurement of a crosslinking property (gel content), measurement of heat shrinkage rate, a high temperature and high humidity durability test, a high temperature durability test, and a weatherability test were carried out for the resin sheet for solar cell encapsulation. The results are shown in Table 1.

Comparative Example 2

A resin sheet for solar cell encapsulation was produced in exactly the same way as in Example 1 except that EVA-4 (vinyl acetate content: 28% by mass, MFR at 190°C under a load of 2160 g: 20 g/10 minutes, Mw/Mn: 3.86) obtained by an autoclave method was used in place of EVA-1. Measurement of a crosslinking property (gel content), measurement of heat shrinkage rate, a high temperature and high humidity durability test, a high temperature durability test, and a weatherability test were carried out for the resin sheet for solar cell encapsulation. The results are shown in Table 1.

[Table 1]

Table 1

| | Example 1 | Example 2 | Example 3 | Example 4 | Example 5 | Comparative Example 1 | Comparative Example 2 |
|---|---|---|---|---|---|---|---|
| Ethylene-vinyl acetate copolymer EV1 | EVA-1 | EVA-2 | EVA-1 | EVA-1 | EVA-1 | EVA-3 | EVA-4 |
| Ethylene-vinyl acetate copolymer EV2 | - | - | EVA-3 | EVA-3 | EVA-3 | - | - |
| Composition ratio EV1/EV2 (mass ratio) | 100/0 | 100/0 | 70/30 | 50/50 | 30/70 | 100/0 | 100/0 |
| Crosslinking property (%) | 91 | 88 | 87 | 86 | 83 | 82 | 81 |
| Heat shrinkage rate (%) | 9 | -15.2 | 14.6 | 16 | 19.1 | 20.2 | 19.8 |
| Total light transmittance (%) after 2000 h at 85°C, 85%RH | 96 | 96 | 96 | 96 | 95 | 95 | 96 |
| Adhesive strength (N/cm) after 2000 h at 85°C, 85%RH | 19 | 19 | 18 | 18 | 19 | 19 | 18 |
| Adhesive strength (N/cm) after 1000 h at 120°C | 20 | 18 | 20 | 19 | 18 | 18 | 19 |
| Adhesive strength (N/cm) after 1500 h of weatherability test | 15 | 14 | 14 | 15 | 14 | 14 | 14 |

As shown in Table 1, in Example 1 and Example 2 using an ethylene-vinyl acetate copolymer having a molecular weight distribution (Mw/Mn) of 3.0 or less, the crosslinking properties were good and the heat shrinkage rates were less than 16%. On the other hand, in Comparative Examples 1 and 2 using only an ethylene-vinyl acetate copolymer having a molecular weight distribution (Mw/Mn) of more than 3.0, the heat shrinkage rates were high.

This application is based upon and claims the benefit of priority from prior Japanese Patent Application No.

2011-089968 filed on April 14, 2011. The entire contents described in the description of the application are incorporated in the description of the present application.

**Industrial Applicability**

A resin sheet for solar cell encapsulation of the present invention has a low shrinkage rate after heating and is excellent in transparency and adhesive strength over a long period of time. Namely, the resin sheet for solar cell encapsulation of the present invention enables sufficient encapsulation of solar cells without causing damage, displacement and/or the like to the solar cells upon manufacturing of a solar cell module. Therefore, a solar cell module excellent in durability can be obtained by using the resin sheet for solar cell encapsulation.

**Claims**

1.   A resin sheet for solar cell encapsulation, comprising:

an ethylene-vinyl acetate copolymer having a vinyl acetate content of 10 to 47% by mass; and
an organic peroxide,
wherein the ethylene-vinyl acetate copolymer contains an ethylene-vinyl acetate copolymer EV1 having a molecular weight distribution (Mw/Mn) of 3.0 or less, and
a content of the organic peroxide is 0.1 to 5% by mass.

2.   The resin sheet according to Claim 1, wherein the ethylene-vinyl acetate copolymer has a melt flow rate MFR of 5 to 45 g/10 minutes at 190°C under a load of 2160 g according to ASTM D 1238.

3.   The resin sheet according to Claim 1, wherein a relation of the vinyl acetate content $C_{VA}$ (% by mass) in the ethylene-vinyl acetate copolymer and a melt flow rate MFR of the ethylene-vinyl acetate copolymer at 190°C under a load of 2160 g according to ASTM D 1238 satisfies the following Expression (1):

$$\text{MFR} > 0.748 \times C_{VA}{}^2 - 35.4 \times C_{VA} + 423 \quad \text{Expression (1).}$$

4.   The resin sheet according to Claim 1, wherein the ethylene-vinyl acetate copolymer EV1 is produced by a tubular method.

5.   The resin sheet according to Claim 1, wherein the ethylene-vinyl acetate copolymer further contains an ethylene-vinyl acetate copolymer EV2 having a molecular weight distribution (Mw/Mn) of more than 3.0.

6.   The resin sheet for solar cell encapsulation according to Claim 5, wherein a mass ratio of the ethylene-vinyl acetate copolymer EV1 to the ethylene-vinyl acetate copolymer EV2, EV1/EV2, is 99/1 to 60/40.

7.   Use of the resin sheet according to Claim 1 for encapsulating a solar cell.

8.   A solar cell module comprising the resin sheet according to Claim 1.

9.   A method for producing a solar cell module including the resin sheet according to Claim 1, comprising:

laminating a solar cell, the resin sheet for solar cell encapsulation, and a protective material in this order and heating the resin sheet for solar cell encapsulation to a temperature at which temperature the organic peroxide does not substantially decompose and the ethylene-vinyl acetate copolymer melts; and
increasing the temperature of the resin sheet for solar cell encapsulation to a temperature equal to or higher than a temperature at which the ethylene-vinyl acetate copolymer crosslink by the organic peroxide in the resin sheet for solar cell encapsulation.

## INTERNATIONAL SEARCH REPORT

| International application No. |
| --- |
| PCT/JP2012/002551 |

**A.  CLASSIFICATION OF SUBJECT MATTER**
*H01L31/048*(2006.01)i, *C08J5/18*(2006.01)i, *C08L23/08*(2006.01)i

According to International Patent Classification (IPC) or to both national classification and IPC

**B.  FIELDS SEARCHED**

Minimum documentation searched (classification system followed by classification symbols)
H01L31/04-31/078, C08J5/18, C08L23/08

Documentation searched other than minimum documentation to the extent that such documents are included in the fields searched

| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
| --- | --- | --- |
| Y | JP 2000-084996 A (Bridgestone Corp.), 28 March 2000 (28.03.2000), paragraphs [0007], [0023], [0025] (Family: none) | 1-9 |
| Y | JP 01-247406 A (Mobil Oil Corp.), 03 October 1989 (03.10.1989), page 3, lower left column, lines 11 to 16 & US 4833111 A          & EP 324588 A2 & AU 2852889 A          & ZA 8900313 A | 1-9 |

| ☒   Further documents are listed in the continuation of Box C. | ☐   See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 28 June, 2012 (28.06.12) | 10 July, 2012 (10.07.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**EP 2 698 830 A1**

INTERNATIONAL SEARCH REPORT

International application No.

PCT/JP2012/002551

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 07-145206 A (Spherilene S.r.l.),<br>06 June 1995 (06.06.1995),<br>paragraph [0002]<br>& US 6300273 B1          & EP 633270 A1<br>& DE 69408222 C          & IT 93501466 A<br>& NO 942548 A            & AU 6618294 A<br>& ES 2113582 T           & FI 943237 A<br>& BR 9402236 A           & DK 633270 T<br>& ZA 9404819 A           & AT 162809 T<br>& CA 2127308 A           & IL 110215 A<br>& RU 2133757 C           & CN 1103406 A<br>& AU 674412 B & A | 1-9 |
| Y | JP 58-052335 A (Tokuyama Soda Co., Ltd.),<br>28 March 1983 (28.03.1983),<br>page 3, lower left column, lines 4 to 6<br>(Family: none) | 1-9 |
| Y | JP 04-233923 A (BASF AG.),<br>21 August 1992 (21.08.1992),<br>paragraphs [0008], [0012], [0030] to [0031]<br>& US 5227445 A          & EP 475124 A2<br>& DE 59106718 C          & DE 4027140 A1<br>& ES 2077744 T | 1-9 |
| Y | JP 2003-002923 A (Tosoh Corp.),<br>08 January 2003 (08.01.2003),<br>entire text; all drawings<br>(Family: none) | 1-9 |
| Y | JP 10-130606 A (Nippon Unicar Co., Ltd.),<br>19 May 1998 (19.05.1998),<br>entire text; all drawings<br>(Family: none) | 1-9 |
| Y | JP 2008-533715 A (E.I. Du Pont De Nemours &<br>Co.),<br>21 August 2008 (21.08.2008),<br>claim 3; paragraph [0015]<br>& US 2008/0169023 A1     & EP 1877455 A1<br>& WO 2006/095911 A1     & CN 101137682 A | 4 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6177412 A
- JP 62273214 A
- JP 11116637 A
- JP 60053513 A
- JP 10130307 A
- JP 2011089968 A